# EUROPEAN PATENT SPECIFICATION

(11) **EP 1 803 836 B1**
(45) Date of publication and mention of the grant of the patent: **25.04.2018**
(21) Application number: 06256598.1
(22) Date of filing: 28.12.2006
(51) Int. Cl.: C23C 14/12, C23C 14/24

(54) **Evaporation source and method of depositing thin film using the same**
Verdampfungsquelle und Verfahren zum Ablagern eines Dünnfilms damit
Source d'évaporation et procédé de dépôt de couches minces l'utilisant

(30) Priority: 28.12.2005 KR 20050131489
(43) Date of publication of application: 04.07.2007
(73) Proprietor: Samsung Display Co., Ltd., Gyeonggi-do (KR)
(72) Inventor: Ahn, Jae Hong, Suwon-si Gyeonggi-do (KR); Jeong, Seok Heon, Yongin-si Gyeonggi-do (KR); Furuno, Kazuo, Suwon-si Gyeonggi-do (KR); Huh, Myung Soo, Suwon-si Gyeonggi-do (KR); Han, Sang Jin, Suwon-si Gyeonggi-do (KR)
(74) Representative: Mounteney, Simon James

(56) References cited:
- EP-A- 1 342 808
- EP-A- 1 777 320
- EP-A1- 0 652 302
- EP-A1- 0 652 303
- EP-A1- 1 443 127
- WO-A-2006/046998
- JP-A- 2006 152 440
- US-A1- 2001 005 553
- US-A1- 2003 026 601
- US-A1- 2005 072 361
- US-B1- 6 237 529

## Description

### BACKGROUND OF THE INVENTION

### 1. Field of the Invention

The present invention relates to an evaporation source and a method for depositing thin films using the same. In particular, the present invention relates to an evaporation source and method for depositing thin films capable of providing uniform film thickness and minimized heat radiation.

### 2. Discussion of the Related Art

Deposition of thin films has numerous manufacturing applications. In semiconductor manufacturing, for example, thin films may be deposited in display devices, such as electroluminescent (EL) display devices, to provide photon-emitting mediums to form images.

Such thin films may be applied to a substrate, e.g., an electrode, by methods such as physical vapor deposition (PVD), e.g., vacuum deposition, chemical vapor deposition (CVD), ion plating, sputtering, and so forth. In the vacuum deposition method, for example, a vacuum environment, e.g., vacuum chamber, may be provided with a substrate. An evaporation source having a heating unit and a deposition material, e.g., organic light-emitting material, may be either connected to the vacuum environment or installed therein, such that the operation of the evaporation source may evaporate the deposition material and form a thin film on the substrate.

An evaporation source may include a crucible to contain a deposition material, a heating unit to heat the crucible and evaporate the deposition material, and at least one spray nozzle to apply the evaporated deposition material to a substrate. Such an evaporation source is for example described in document US 2001/0005553 A1.

However, the particles of the evaporated deposition material may have a tendency to coalesce and form clusters of particles having various sizes, thereby providing an evaporated deposition material having non-uniform texture and density consistency. Further, such non-uniform evaporated deposition material may cause application of non-uniform layers of deposition material onto substrates, thereby producing films lacking uniform thickness.

Additionally, application of the evaporated deposition material through a conventional spray nozzle onto a substrate may radiate excess heat into a processing chamber, thereby deforming the substrate upon contact therewith.

Further, application of deposition material to a rotatable substrate may require a large size of a processing chamber in order to accommodate sufficient space for substrate movement. Such large substrates may also sag or collapse as a result of upward application of deposition material thereon.

Accordingly, there remains a need for an evaporation source and a method of using the same providing thin films having uniform thickness, while minimizing excess heat radiation and processing chamber size.

### SUMMARY OF THE INVENTION

The present invention is therefore directed to an evaporation source and method of employing the same, which substantially overcome one or more of the disadvantages of the related art.

The invention accordingly sets out to provide an evaporation source and a method employing the same having the capability of minimizing the coalescence of the evaporated deposition material, thereby improving uniformity of thin deposition layers.

The invention also aims to provide an evaporation source and a method employing the same having a nozzle structure with improved heat radiation distribution, thereby minimizing excessive heat transfer into a processing chamber.

It is yet another object of the present invention to provide an evaporation source and a method employing the same, providing reduced size of processing chamber and substrate.

In view of the above, a first aspect of the invention provides an evaporation source as set out in claim 1. Preferred features of this aspect of the invention are set out in claims 2 to 8.

A second aspect of the invention provides a method of depositing a thin film as set out in Claim 9. Preferred features of this aspect of the invention are set out in claims 10 to 13.

### BRIEF DESCRIPTION OF THE DRAWINGS

Embodiments of the invention will now be described by way of example and with reference to the accompanying drawings, in which:
FIG. 1 illustrates a perspective view of an apparatus for depositing a thin films using an evaporation source according to an embodiment of the present invention;
FIG. 2A illustrates a cross-sectional view of an evaporation source according to an embodiment of the present invention taken along the line I-I' of FIG. 1;
FIG. 2B illustrates a cross-sectional view of a direction of movement of an evaporated deposition material inside an evaporation source according to an embodiment of the present invention taken along the line I-I' of FIG. 1;
FIG. 3A illustrates a plan view of an evaporation source according to an embodiment of the present invention taken along the line II-II' of FIG. 1; and
FIG. 3B illustrates a plan view of a direction of movement of an evaporated deposition material inside an evaporation source having a shower head structure according to an embodiment of the present invention taken along the line 1I-II' of FIG. 1.

### DETAILED DESCRIPTION OF PREFERRED EMBODIMENTS

The present invention will now be described more fully hereinafter with reference to the accompanying drawings, in which embodiments of the invention are illustrated. The invention may, however, be embodied in different forms and should not be construed as limited to the embodiments set forth herein. Rather, these embodiments are provided so that this disclosure will be thorough and complete, and will fully convey the scope of the invention to those skilled in the art.

In the figures, the dimensions of layers and elements may be exaggerated for clarity of illustration. It will also be understood that when a layer or element is referred to as being "on" another layer, element, or substrate, it can be directly on the other layer, element, or substrate, or intervening layers/elements may also be present. Further, it will be understood that when a layer or element is referred to as being "under" another layer or element, it can be directly under, or one or more intervening layers or elements may also be present. In addition, it will also be understood that when a layer or element is referred to as being "between" two layers or elements, it can be the only layer or element between the two layers/elements, or one or more intervening layers or elements may also be present. Like reference numerals refer to like elements throughout.

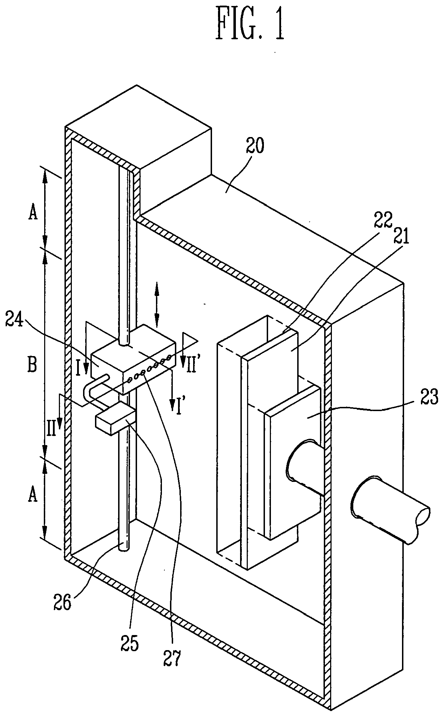

An embodiment of an apparatus containing an evaporation source in accordance with the present invention will now be more fully described with reference to FIG. 1.

As illustrated in FIG. 1, an apparatus for depositing thin films according to an embodiment of the present invention includes a processing chamber 20, a supporting unit 23 for securing a substrate, an evaporation source 24, and a deposition rate measuring unit 26 coupled to the evaporation source 24.

The processing chamber 20 of an embodiment of the present invention may be any type of vessel known by those skilled in the art for use in film processing, and, preferably, it may be a pressure-controlled vessel such as a vacuum chamber. The processing chamber 20 is in this case formed to have a deposition preventing part A and a film forming part B.

The film forming part B, as illustrated in FIG. 1, refers to the central area of the processing chamber 20. The central area of the processing chamber 20 corresponds to a position where a substrate may be placed and formation of a film, e.g., vacuum deposition processing, may occur. The deposition preventing part A, as illustrated in FIG. 1, refers to the area inside the processing chamber 20 that surrounds the film forming part B. In other words, the deposition preventing part A is formed as peripheral portions of film forming part B. The peripheral portions, i.e., deposition preventing part A, are excluded from film deposition processing. The deposition preventing part A may include a heat absorbing plate (not shown) formed around a substrate to remove excess heat from the substrate and provide uniform temperature and uniform film thickness.

In the embodiment illustrated in FIG. 1, a substrate 21 and a mask 22 are in use, placed in the processing chamber 20. In particular, the substrate 21 and mask 22 are placed in the center of the processing chamber 20, i.e., film forming part B, such that the deposition preventing part A surrounds them. The mask 22 is attached to the substrate 21 between the substrate 21 and the evaporation source 24. The mask 22 may include a pattern formation unit (not shown) having a pattern corresponding to a pattern to be imparted to a thin film formed on the substrate 21, and a fixation unit (not shown) secured to a mask frame (not shown) through welding.

The supporting unit 23 of this embodiment of the present invention is coupled to the processing chamber 20 in order to secure the substrate 21 and the mask 22 in the film forming part A of the processing chamber 20, as illustrated in FIG. 1. The supporting unit 23 is formed as a longitudinal member connected to the processing chamber 20 at one end and to a substrate at the other end, such that a substrate may be stably secured in its position. Additionally, an alignment system (not shown) may be added to align the substrate 21 and the mask thereon.

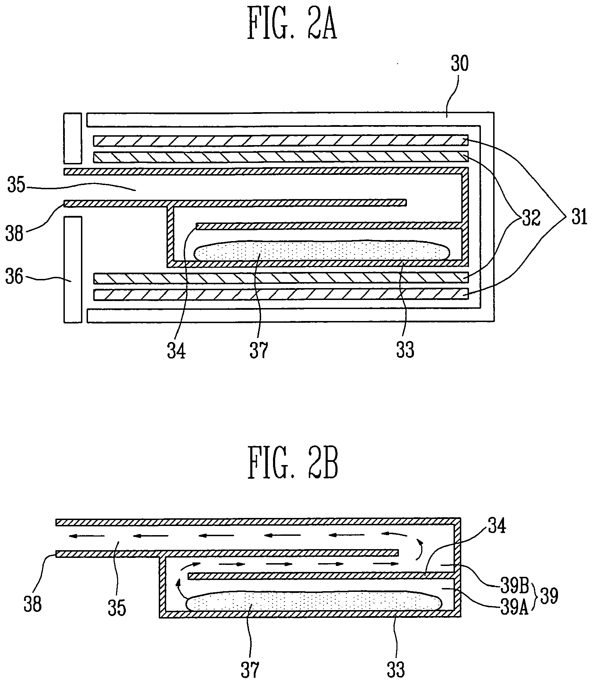

In use, the evaporation source 24 supplies sufficient heat to evaporate a deposition material placed therein, and, subsequently, apply it to a substrate in order to form a thin film. The detailed structure of the evaporation source 24 will be described in more detail with respect to FIGS. 2A-3B.

The evaporation source 24 of this embodiment of the present invention includes a crucible 33 for storing a deposition material 37, a heating unit 32 for evaporating the deposition material 37, at least one spray nozzle 38 for spraying the deposition material 37 onto the substrate 21, and a baffle 34 inside the crucible 33. The above mentioned components are enclosed by a housing 30.

The crucible 33 is formed to include a predetermined space for containing the deposition material 37 to be deposited onto the substrate 21, and it may be formed of any material known in the art that has excellent heat conductivity. In particular, the crucible 33 may be formed of a ceramic material, e.g., graphite, silicon carbide (SiC), aluminum nitride (AIN), alumina (Al₂O₃), boron nitride (BN), quartz, and so forth, or of a metal, e.g., titanium (Ti), stainless steel, and so forth.

The crucible 33 further includes a baffle 34. Other embodiments may have more than one baffle. The baffle 34 is formed inside the crucible 33 in a form of plurality of baffle plates, as illustrated in FIGS. 2A-2B. The baffle 34 is formed of any suitable material known in the art, and it is positioned parallel to the predetermined space containing the deposition material 37 to divide the crucible into a plurality of channels 39, as further illustrated in FIGS. 2A-2B. The plurality of channels 39 include two channels that form a labyrinthine movement path for the evaporated deposition material 37 from the crucible 33 to the induction channel 35.

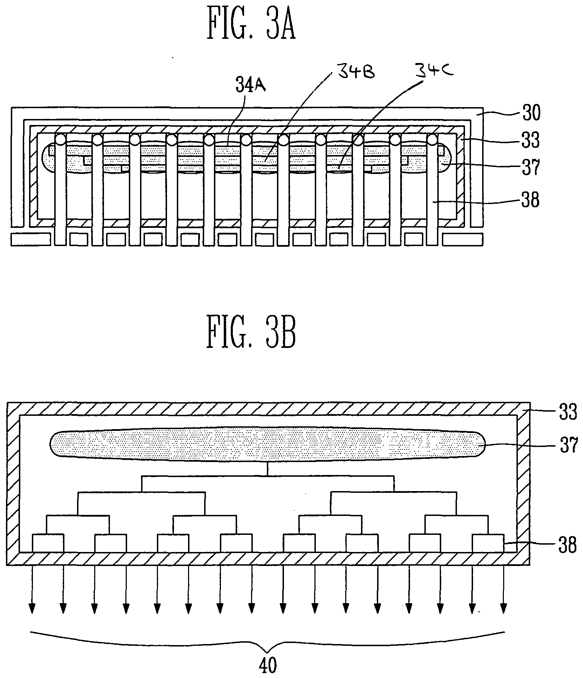

Another embodiment including a plurality of baffle plates, (in this case three baffle plates 34A, 34B, and 34C), is shown in FIG. 3A. In this embodiment the baffle plates are arranged parallel to each other throughout the width of the crucible 33 in such a way that a labyrinth is formed along the path of movement of the evaporated deposition material 37.

Without intending to be bound by theory, it is believed that, when the crucible 33 is heated by the heating unit 32, the deposition material 37 evaporates and flows from the crucible 33 through the baffle 34 and the plurality of channels 39 towards the induction channel 35. The flow of the evaporated deposition material 37 collides with the baffle 34 and, thereby, enhances break-up of any coalesced clusters of the evaporated deposition material 37. Such cluster break-up enhances the uniformity of the evaporated deposition material in terms of texture and density, i.e., the evaporated deposition material includes particles having substantially similar dimensions.

The deposition material 37 may be any type of material employed in the art for forming thin films in display devices. For example, the deposition material may be a light-emitting material or, more preferably, an organic light-emitting material.

The heating unit 32 includes at least one heater (not shown). The evaporation source 24 includes two heating units 32, each heating unit 32 having at least one electrical heater (not shown). As such, the heating unit 32 may be formed in close proximity to the crucible 33 to provide sufficient heat to evaporate the deposition material 37 contained therein. One heating unit 32 is located on each horizontal side of the crucible 33, as illustrated in FIG. 2A.

A reflector 31 is provided between each heating unit 32 and the housing 30 surrounding the crucible 33. The evaporation source 24 includes a plurality of reflectors 31 formed in close proximity to the heating units 32 to reflect heat emitted from the heating units 32 into the crucible 33, thereby minimizing heat leakage outside the evaporation source 24.

The spray nozzle 38 is situated in the housing 30, and protrudes through the housing 30. The spray nozzle 38 is connected to an induction channel 35, which may then direct the deposition material 37 from the crucible 33 into the nozzle 38, as illustrated in FIG. 2B. The spray nozzle 38 has a shower head structure, as illustrated in FIG. 3B. In other words, the spray nozzle 38 includes a plurality of nozzle orifices 40 formed through the housing 30, such that application of the evaporated deposition material 37 through the plurality of nozzle orifices 40 may be simultaneous and uniform. As further illustrated in FIG. 3B, the plurality of nozzle orifices 40 are in fluid communication with the deposition material 37 through a plurality of channels.

Without intending to be bound by theory, it is believed that application of the evaporated deposition material 37 through the shower head structure of the spray nozzles 38 distributes the heat generated in the crucible 33 over a larger surface area during application, thereby reducing the amount of heat released from the crucible 33 into the process chamber 20 and the substrate 21, and further minimizing deformation of the substrate 21 and the mask 22 due to excess heat.

The housing 30 may be formed to include a double wall having an internal wall (not shown) and an external wall (not shown). The double wall structure may provide sufficient space between the internal and external walls for cooling water to facilitate temperature control.

The evaporation source 24 of the above described first embodiment of the present invention also includes an insulating plate 36 between the crucible 33 and the inside wall of the housing 30. The insulating plate 36 may minimize heat transfer from the induction channel 35 into the processing chamber 20 and the substrate 21.

The evaporation source 24 is moveable. In particular, the evaporation source 24 is formed on a driving shaft 26. The driving shaft 26 is formed parallel to the longitudinal side of the substrate 21 inside the processing chamber 20. The driving shaft 26 includes a rotary unit (not shown) that may rotate and move the evaporation source 24 along the driving shaft 26, such that the evaporation unit 24 may move up and down along the driving shaft 26 in a direction perpendicular to the direction of the rotation of the driving shaft 26. In this regard, it should be noted that without intending to be bound by theory, it is believed that employing a movable evaporation source 24 reduces the size of the processing chamber 20 by at least about 75% as compared to a size of a processing chamber having a stationary evaporation source and a rotatable substrate.

The evaporation source 24 further includes a deposition rate measuring unit 25. The deposition rate measuring unit 25 is affixed to the evaporation source 24, such that the deposition rate measuring unit 25 and the evaporation source 24 may move jointly. The deposition rate measuring unit 25 may also be integral with the evaporation source 24. The joint motion of the deposition rate measuring unit 25 and the evaporation source 24, whether integrated or not, allows continuous real-time measurement of the evaporation rate of the deposition material and control of its deposition rate onto the substrate 21.

The deposition rate measuring unit 25 may also have the capability of adjusting the evaporation rate of the deposition material in order to achieve a specific deposition rate onto a substrate. For example, the deposition rate measuring unit 25 may be electrically connected to the heating unit 32 of the evaporation source 24, such that the heat amount generated for evaporating the deposition material 37 in the evaporation source 24 may be increased or decreased with respect to a desired deposition rate. Similarly, the deposition rate measuring unit 25 may be electrically connected to the rotary unit of the driving shaft 26, such that the speed at which the evaporation source 24 moves may be increased or decreased with respect to the generated amount of the evaporated deposition material 37. The control of the evaporation source 24 speed may facilitate control of the exposure time of the substrate 21 to the evaporation source 24, i.e., deposition rate.

A method of depositing a thin film onto a substrate in accordance with the invention is described below with reference to FIGS. 1-2B.

The substrate 21 is placed in the processing chamber 20, and secured therein with the supporting unit 23. The mask 22 is attached to the surface of the substrate 21 to be coated. Next, the evaporation source 24 is provided in the processing chamber 20, such that the evaporation source 24 faces the surface of the substrate 21 that is to be coated.

Once the processing chamber 20 is set, a deposition material 37, e.g., a metal or a light-emitting material such as an organic light-emitting material employed in manufacturing of organic-light emitting diodes (OLEDs), is placed in the crucible 33 of the evaporation source 24.

The heating unit 32 of the evaporation source 24 is activated to heat the crucible 33, such that the deposition material 37 placed therein is evaporated, e.g., gasified or sublimated. The evaporated deposition material 37 then passes around at least one baffle plate of the baffle 34 to form a uniform deposition fluid having substantially uniform texture and density, and the uniform deposition fluid continues through channels 39 into the induction channel 35, and, subsequently, into the spray nozzle 38. Preferably, the evaporation temperatures in the evaporation source 24 are low, i.e., they range from about 200°C to about 400°C.

The evaporated deposition material 37 is applied to the substrate 31 by any means known in the art, e.g., spraying. Spraying may be done, for example, by dispersion of the evaporated deposition material 37 through the spray nozzle 38, such that only the heat generated in the crucible 33 by the evaporation process, i.e., heat generated due to enthalpy of evaporation of the deposition material 37, as opposed to heat produced by the heating unit 32, is released, thereby providing improved control of the heat reaching the substrate 21. The deposition rate may also be adjusted, as previously discussed with respect to the operation of the deposition rate measuring unit 25, in order to control the thickness and uniformity of the thin film and provide reproducibility of injected impurities. Once the deposition material is successfully applied to the substrate 21, it may solidify to form a thin film.

Embodiments of the present invention have been disclosed herein as examples, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. An evaporation source, comprising:
a crucible (33) including a predetermined space for placing a deposition material and at least one baffle (34), the baffle (34) being positioned inside the crucible (33);
a heating unit (32); and
at least one spray nozzle (38) in fluid communication with the crucible (38), the spray nozzle (38) having a plurality of spray orifices; wherein
the baffle (34) comprises a plurality of baffle plates positioned parallel to the predetermined space to divide the crucible (33) into a plurality of channels (39) that provide a labyrinthine movement path through which evaporated deposition material can pass towards an induction channel (35) that is parallel to the predetermined space;
the at least one spray nozzle (38) being extended from the induction channel (35).

2. An evaporation source as claimed in claim 1, wherein the plurality of baffle plates comprises at least three parallel baffle plates.

3. An evaporation source as claimed in any preceding claim, further comprising a deposition rate measuring unit (25).

4. An evaporation source as claimed in any preceding claim, further comprising at least one reflector (31) positioned between the heating unit and a housing wall of the evaporation source (32).

5. An evaporation source as claimed in any preceding claim, further comprising an insulating plate (36).

6. An evaporation source as claimed in claim 5, wherein the or each spray nozzle protrudes through the insulating plate (36).

7. An evaporation source as claimed in any preceding claim, wherein the evaporation source is movable.

8. An evaporation source as claimed in any preceding claim, wherein the deposition material is an organic light-emitting material.

9. A method of depositing a thin film, comprising:
providing, in a processing chamber, an evaporation source comprising a crucible (33) including a predetermined space for placing a deposition material and at least one baffle (34), the baffle (34) being positioned inside the crucible (33),
a heating unit (32), and at least one spray nozzle (38) in fluid communication with the crucible (33), the spray nozzle (38) having a plurality of spray orifices, wherein the baffle (34) comprises a plurality of baffle plates positioned parallel to the predetermined space to divide the crucible (33) into a plurality of channels (39) that provide a labyrinthine movement path through which evaporated deposition material can pass towards an induction channel (35) that is parallel to the predetermined space, the at least one spray nozzle (38) being extended from the induction channel (35);
placing a substrate in the processing chamber, such that a surface of the substrate to be coated is facing the evaporation source;
activating the heating unit (32), such that a deposition material in the crucible (33) is evaporated;
passing the evaporated deposition material through the baffle (34) of the crucible (33) to form a substantially uniform deposition fluid; and
spraying the deposition fluid through the at least one spray nozzle (38) onto the substrate to form a thin film.

10. A method as claimed in claim 9, further comprising operating a deposition rate measuring unit (25).

11. A method as claimed in claim 9 or 10, wherein spraying the uniform deposition fluid comprises moving the evaporation source.

12. A method as claimed in one of claims 9 to 11, wherein activating the heating unit (32) comprises evaporating an organic light-emitting material.

13. A method as claimed in one of claims 9 to 12, further comprising providing a vacuum environment in the processing chamber.

## Patentansprüche

1. Bedampfungsquelle, die Folgendes umfasst:
einen Tiegel (33), der einen vorbestimmten Raum zum Platzieren eines Abscheidungsmaterials und wenigstens einen Ablenker (34) einschließt, wobei der Ablenker (34) innerhalb des Tiegels (33) angeordnet ist,
eine Heizeinheit (32) und
wenigstens eine Sprühdüse (38) in Fluidverbindung mit dem Tiegel (33), wobei die Sprühdüse (38) mehrere Sprühöffnungen hat, wobei
der Ablenker (34) mehrere Ablenkplatten umfasst, die parallel zu dem vorbestimmten Raum angeordnet sind, um den Tiegel (33) in mehrere Kanäle (39) zu teilen, die eine labyrinthische Bewegungsbahn bereitstellen, durch die verdampftes Abscheidungsmaterial zu einem Einleitungskanal (35) hindurchgehen kann, der parallel zu dem vorbestimmten Raum ist,
sich die wenigstens eine Sprühdüse (38) von dem Einleitungskanal (35) aus erstreckt.

2. Bedampfungsquelle nach Anspruch 1, wobei die mehreren Ablenkplatten wenigstens drei parallele Ablenkplatten umfassen.

3. Bedampfungsquelle nach einem der vorhergehenden Ansprüche, die ferner eine Abscheidungsrate-Messeinheit (25) umfasst.

4. Bedampfungsquelle nach einem der vorhergehenden Ansprüche, die ferner wenigstens einen Reflektor (31) umfasst, der zwischen der Heizeinheit und einer Gehäusewand der Bedampfungsquelle (32) angeordnet ist.

5. Bedampfungsquelle nach einem der vorhergehenden Ansprüche, die ferner eine Isolierplatte (36) umfasst.

6. Bedampfungsquelle nach Anspruch 5, wobei die oder jede Sprühdüse durch die Isolierplatte (36) vorspringt.

7. Bedampfungsquelle nach einem der vorhergehenden Ansprüche, wobei die Bedampfungsquelle beweglich ist.

8. Bedampfungsquelle nach einem der vorhergehenden Ansprüche, wobei das Abscheidungsmaterial ein organisches Licht emittierendes Material ist.

9. Verfahren zum Abscheiden eines Dünnfilms, das Folgendes umfasst:
Bereitstellen, in einer Bearbeitungskammer, einer Bedampfungsquelle, umfassend einen Tiegel (33), der einen vorbestimmten Raum zum Platzieren eines Abscheidungsmaterials und wenigstens einen Ablenker (34) einschließt, wobei der Ablenker (34) innerhalb des Tiegels (33) angeordnet ist,
eine Heizeinheit (32) und wenigstens eine Sprühdüse (38) in Fluidverbindung mit dem Tiegel (33), wobei die Sprühdüse (38) mehrere Sprühöffnungen hat, wobei der Ablenker (34) mehrere Ablenkplatten umfasst, die parallel zu dem vorbestimmten Raum angeordnet sind, um den Tiegel (33) in mehrere Kanäle (39) zu teilen, die eine labyrinthische Bewegungsbahn bereitstellen, durch die verdampftes Abscheidungsmaterial zu einem Einleitungskanal (35) hindurchgehen kann, der parallel zu dem vorbestimmten Raum ist, wobei sich die wenigstens eine Sprühdüse (38) von dem Einleitungskanal (35) aus erstreckt,
Platzieren eines Substrats in der Bearbeitungskammer, so dass eine zu beschichtende Oberfläche des Substrats zu der Bedampfungsquelle zeigt,
Aktivieren der Heizeinheit (32), so dass ein Abscheidungsmaterial in dem Tiegel (33) verdampft wird,
Führen des verdampften Abscheidungsmaterials durch den Ablenker (34) des Tiegels (33), um ein im Wesentlichen gleichförmiges Abscheidungsfluid zu bilden, und
Sprühen des Abscheidungsfluids durch die wenigstens eine Sprühdüse (38) auf das Substrat, um einen Dünnfilm zu bilden.

10. Verfahren nach Anspruch 9, das ferner das Betreiben einer Abscheidungsrate-Messeinheit (25) umfasst.

11. Verfahren nach Anspruch 9 oder 10, wobei das Sprühen des gleichförmigen Abscheidungsfluids das Bewegen der Bedampfungsquelle umfasst.

12. Verfahren nach einem der Ansprüche 9 bis 11, wobei das Aktivieren der Heizeinheit (32) das Verdampfen eines organischen Licht emittierenden Materials umfasst.

13. Verfahren nach einem der Ansprüche 9 bis 12, das ferner das Bereitstellen einer Vakuumumgebung in der Bearbeitungskammer umfasst.

## Revendications

1. Source d'évaporation, comprenant :
un creuset (33) incluant un espace prédéterminé pour placer un matériau de dépôt, et au moins une chicane (34), la chicane (34) étant positionnée à l'intérieur du creuset (33) ;
une unité de chauffage (32) ; et
au moins une buse de pulvérisation (38) en communication de fluide avec le creuset (38), la buse de pulvérisation (38) comportant plusieurs orifices de pulvérisation ; dans laquelle :
la chicane (34) comprend plusieurs plaques déflectrices positionnées de manière parallèle à l'espace prédéterminé pour diviser le creuset (33) en plusieurs canaux (39), pour établir un trajet de déplacement labyrinthique à travers lequel du matériau de dépôt évaporé peut passer vers un canal d'induction (35) qui est parallèle à l'espace prédéterminé ;
la au moins une buse de pulvérisation (38) s'étendant à partir du canal d'induction (35).

2. Source d'évaporation selon la revendication 1, dans laquelle les plusieurs plaques déflectrices comprennent au moins trois plaques déflectrices.

3. Source d'évaporation selon l'une quelconque des revendications précédentes, comprenant en outre une unité de mesure du dépôt (25).

4. Source d'évaporation selon l'une quelconque des revendications précédentes, comprenant en outre au moins un réflecteur (31) positionné entre l'unité de chauffage et une paroi du logement de la source d'évaporation (32).

5. Source d'évaporation selon l'une quelconque des revendications précédentes, comprenant en outre une plaque d'isolation (36).

6. Source d'évaporation selon la revendication 5, dans laquelle la ou chaque buse de pulvérisation fait saillie à travers la plaque d'isolation (36).

7. Source d'évaporation selon l'une quelconque des revendications précédentes, dans laquelle la source d'évaporation est mobile.

8. Source d'évaporation selon l'une quelconque des revendications précédentes, dans laquelle le matériau de dépôt est un matériau organique émetteur de lumière.

9. Procédé de dépôt d'un film mince, comprenant les étapes ci-dessous :
agencement, dans une chambre de traitement, d'une source d'évaporation comprenant un creuset (33) incluant un espace prédéterminé pour placer un matériau de dépôt, et au moins une chicane (34), la chicane (34) étant positionnée à l'intérieur du creuset (33),
une unité de chauffage (32) et au moins une buse de pulvérisation (38) en communication de fluide avec le creuset (33), la buse de pulvérisation (38) comportant plusieurs orifices de pulvérisation, la chicane (34) comprenant plusieurs plaques déflectrices positionnées de manière parallèle à l'espace prédéterminé pour diviser le creuset (33) en plusieurs canaux (39) qui établissent un trajet de déplacement labyrinthique à travers lequel du matériau de dépôt évaporé peut passer vers un canal d'induction (35) parallèle à l'espace prédéterminé, la au moins une buse de pulvérisation (38) s'étendant à partir du canal d'induction (35) ;
placement d'un substrat dans la chambre de traitement, de sorte qu'une surface du substrat devant être revêtue fait face à la source d'évaporation ;
activation de l'unité de chauffage (32), de sorte qu'un matériau de dépôt dans le creuset (33) est évaporé ;
passage du matériau de dépôt évaporé à travers la chicane (34) du creuset (33) pour former un fluide de dépôt sensiblement uniforme ; et
pulvérisation du fluide de dépôt à travers la au moins une buse de pulvérisation (38) sur le substrat pour former un film mince.

10. Procédé selon la revendication 9, comprenant en outre l'étape d'actionnement d'une unité de mesure du taux de dépôt (25).

11. Procédé selon les revendications 9 ou 10, dans lequel l'étape de pulvérisation du fluide de dépôt uniforme comprend le déplacement de la source d'évaporation.

12. Procédé selon l'une des revendications 9 à 11, dans lequel l'étape d'activation de l'unité de chauffage (32) comprend l'évaporation d'un matériau organique émetteur de lumière.

13. Procédé selon l'une des revendications 9 à 12, comprenant en outre l'étape d'établissement d'un environnement sous vide dans la chambre de traitement.
